# EUROPEAN PATENT APPLICATION

(11) **EP 2 249 381 A1**
(43) Date of publication of application: **10.11.2010**
(21) Application number: 09712660.1
(22) Date of filing: 16.02.2009
(51) Int. Cl.: H01L 21/822, H01L 21/60, H01L 25/04, H01L 25/065, H01L 25/07, H01L 25/18, H01L 27/04

(54) **SEMICONDUCTOR CHIP AND SEMICONDUCTOR DEVICE**

(30) Priority: 19.02.2008 JP 2008037452
(71) Applicant: Liquid Design Systems, Inc., Kanagawa 213-0012 (JP)
(72) Inventor: MABUCHI, Yoshihiro, Kawasaki-shi Kanagawa 213-0012 (JP)
(74) Representative: Fuhlendorf, Jörn
(86) International application number: PCT/JP2009/052493
(87) International publication number: WO 2009/104536

(57) **Abstract**

To provide a sem conductor chip whose number of electrodes are minimized while the horizontal position between the semiconductor chip and the mounted substrate is maintained in implementation to avoid any connection problem, as well as to prevent the damage to the semiconductor circuit of such chip.

For example, there is a cross-shaped connection bump disposition area 23 which is formed by memory banks 22A-22D which face with each other with a certain distance. And in the area 23A in the cross-shaped connection bump disposition area 23, signal input output connection bumps 21A (the first electrodes) are disposed and form a group. On the other hand, by disposing a group of power/grounding connection bumps 21 B in the area 23B which crosses in the right angle with the area 23A where a group of the signal input output connection bumps 21A is disposed, forming a group, the memory chip 20 is supported by the power/grounding bumps 21B (via soldering) so that it will not tilt when implemented on the wiring chip 10, thus, its horizontal position is maintained by the minimum number of bumps. For example, the memory chip 20 is composed as such.

## Description

### Technical Filed

This invention is with respect to a semiconductor chip (for example, a memory chip, a logic circuit chip, and so on) and a semiconductor device which comprises such a chip.

### Background Art

Nowadays, as LSIs become larger and the process technologies become more complicated, an approach called SIP (System In Package), which is to include multiple different chips in one package, is becoming common. This approach enables multi-functionalities of a device by mixing and matching semiconductor chips from multiple venders as well as chips with different functionalities, such as optical and mechanical chips.

One of the examples to iriplement such high-density chips, for example, is the flip-chip method, which is to place additional wires as necessary on the top of the main surface of the semiconductor chip where semiconductor circuits are comprised, then fabricate solder bumps, gold bumps, or copper bumps, place the mounted substrate facing with the main surface of the semiconductor chip, and press them by a pressure bonding.

By the way, conventionally, there have been several proposals with respect to semiconductor chips to modify the location or shapes of electrodes as well as to modify the implementation structures to achieve various objectives in the past. (For example, the Patent document 1-7).

And for example in order to increase the processing speed, a method to divide the fabrication areas of semic onductor circuits (memory circuits and logic circuits) which are to be formed on a semiconductor chip is adopted. Also, a method to collectively place electrodes around the center of the spacing areas formed by the fabrication areas ofthe semiconductor circuits which had been divided is adopted. This method is utilized in order to increase the efficiency when forming signal input/output wires fc r the divided semiconductor circuits, as well as to minimize the space which electrodes occupy on the semiconductor chip.

Also, in general, a bandwidth (transfer rate) is known as one of the parameters to indicate the processing speed of a semiconductor chip. The bandwidth is defined as a multiple of a semiconductor device's operational frequency and the number of input/output data (input/output bit number) of the semiconductor device. Taking a general DDR and/or DRAM as an example, when the operational frequency of the semiconductor device is 166MHz and the number of input/output data of the semiconductor device is 32, the bandwidth is 0.66GB/second.
Patent document 1: Japanese Patent Laid-Open Publication Hei 7-263449
Patent document 2: Japanese Patent Laid-Open Publication No. 2000-188381
Patent document 3: Japanese Patent Laid-Open Publication No. 2000-315776
Patent document 4: Japanese Patent Laid-Open Publication No. 2002-26037
Patent document 5: Japanese Patent Laid-Open Publication No. 2003-258154
Patent document 6: Japanese Patent Laid-Open Publication No. 2006-147629
Patent document 7: Japanese Patent Laid-Open Publication No. 2007-529930

### Disclosure of the Invention

### Problems to be sold by the Invention

However, the method to collectively place the electrodes in the center of the semiconductor chip makes it difficult to keep the horizontal position between the semiconductor chip and the mounted substrate (including a wiring chip) when the chip is implemented as a flip-chip (in other words, the semiconductor chip is likely to be tilted from the mounted substrate when implemented), which may cause connection problems.

On the other hand, if the electrodes are placed up to the surface of the fabrication area of the semiconductor circuit in order to keep the horizontal position between the semiconductor chip and the mounted substrate, the semiconductor circuit may be damaged due to a physical pressure caused during implementation, which affects the reliability of the device.

Thus, the challenge relating to the present invention is to provide a semiconductor chip as well as a semiconductor device which comprises such a chip whose number of electrodes are minimized while the horizontal position between the semiconductor chip and the mounted substrate is maintained in implementation to avoid any connection problem, as well as to prevent the damage to the semiconductor circuit of such chip.

### Means to solve the problems

The challenges are resolved as follow. In other words, the semiconductor chip relating to the Claim 1 is a semiconductor chip, comprising:
four first to fourth rectangular-shaped semiconductor circuit forming areas, in which semiconductor circuits are respectively formed, and which are disposed such that two sides of the respective semiconductor circuit forming areas which intersect at a right angle face each other at predetermined intervals;
a cross-shaped electrode-disposition area constructed by first and second areas formed by gaps between the first to fourth semiconductor circuit forming areas and intersecting at a right angle;
a first electrode group which is disposed at least in a part of the first area of the cross-shaped electrode-disposition area, is connected to the semiconductor circuits, and supplies power or signals to the semiconductor circuits; and
a second electrode group which is disposed at least in a part of the second area of the cross-shaped electrode-disposition area, is connected to the semiconductor circuits, and supplies power or signals to the semiconductor circuits.

The invention relating to the Claim 2 is a semiconductor chip according to claim 1, wherein the first electrode group includes electrodes for signal input and output, and the second electrode group includes electrodes for power supply and grounding.

The invention relating to the Claim 3 is a semiconductor chip according to claim 1 or 2, wherein the semiconductor circuit is a memory circuit, and the semiconductor chip is a memory device chip.

The invention relating to the Claim 4 is a semiconductor device, comprising:
a wiring chip,
a first semiconductor chip mounted on a main face of the wiring chip with an electrode group thereof facing the main face; and
a second semiconductor chip which is different from the first semiconductor chip and is mounted on the main face of the wiring chip with an electrode group thereof facing the main face, wherein
the second semiconductor chip is the semiconductor chip according to any one of claims 1 to 3.

The invention relating to the Claim 5 is a semiconductor device, comprising:
a first semiconductor chip; and
a second semiconductor chip which is different from the first semiconductor chip and is mounted on a main face of the first semiconductor chip with an electrode group thereof facing the main face, wherein
the second semiconductor chip is the semiconductor chip according to any one of claims 1 to 3.

### Effect of the Invention

The present inver tion minimizes the number of electrodes, allows horizontal position with the mounted substrate in implementation thus avoiding any connection problem as well as avoiding any damage to the semiconductor circuits.

### Brief Explanation of Drawings

Fig. 1 is a view showing the semiconductor device in which the present invention is implemented.
Fig. 2 is a cross-sectional view ofthe Fig. 1, A-A.
Fig. 3 is a cross-sectional view of the Fig. 1, B-B.
Fig. 4 is a view showing the memory chip included in the semiconductor device in which the present invention is implemented.
Fig. 5 is a view showing a memory chip included in the semiconductor device in which the present invention is implemented in another form.
Fig. 6 is a view showing a memory chip included in the semiconductor device in which the present invention is implemented in another form.
Fig. 7 is a view showing a memory chip included in the semiconductor device in which the present invention is implemented in another form.
Fig. 8 is a view showing the semiconductor device in which the present invention is implemented in another form.
Fig. 9 is a view showing a memory chip included in the semiconductor device in which the present invention is implemented in another form.
Fig. 10 is a cross-sectional view of the Fig. 9, C-C.

### Preferred Exemplary of the Invention

The best exemplary embodiment of the present invention is explained as follows. The present is not limited to the embodiment below. In order to make the explanation clear, following descriptions and figures may be omitted or simplified as necessary. A person skilled in the art can change, add, or convert each element of the embodiment within the scope of the invention. Symbols having the same names have the same structural element and their explanations are omitted as necessary.

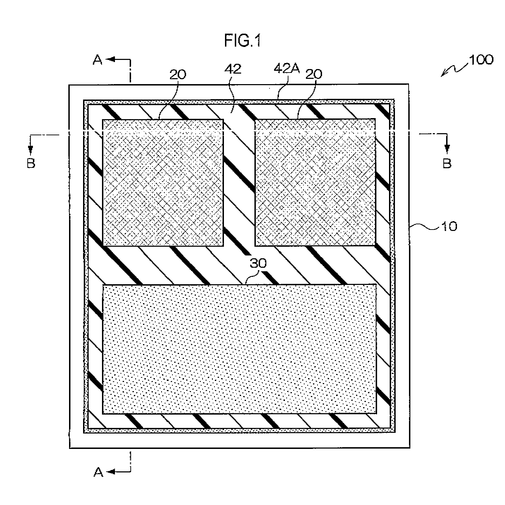

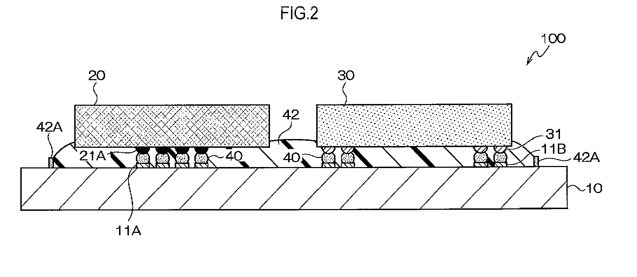

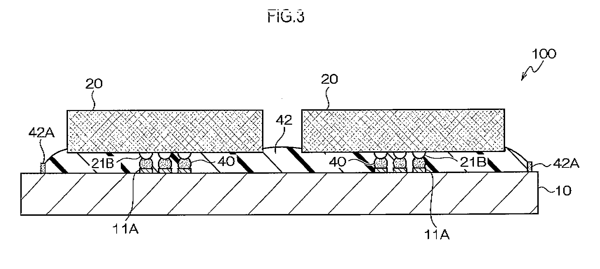

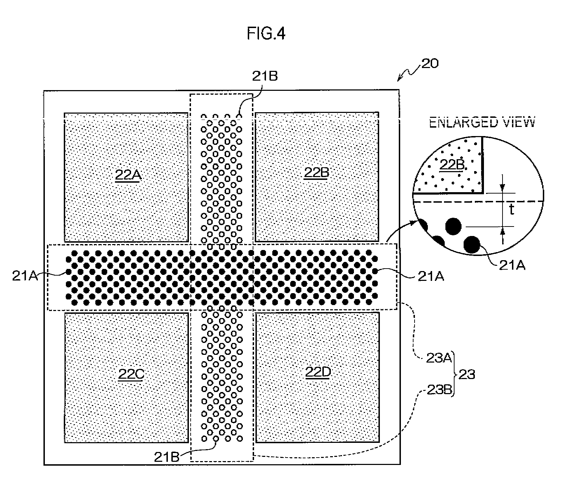

Fig. 1 is a view showing the configuration of the semiconductor memory device in which the present invention is implemented. Fig. 2 is a cross-sectional view of the Fig. 1, A-A. Fig. 3 is a cross-sectional view of the Fig. 1, B-B. Fig. 4 is a view showing the memory chip included in the semiconductor device in which the present invention is implemented.

The semiconductor device 100, as shown in Fig. 1-3, is implemented as a flip chip where two units of memory chips 20 and the Application Specific Chip (hereinafter referred as "ASIC": the first semiconductor chip) 30 are implemented on the same main surface of the wiring chip 10 which serves as an interposer (mounted substrate). The two memory chips 20 and the ASIC 30 are disposed in such a way that each line of the two memory chips and one line of the ASIC 30 face with each other. And the underfill resin 40 (sealant) is filled between the wiring chip 10, the memory chips 20, and the ASIC 30. The underfill resin 42 is filled and stopped by the dam material 42A (material to stop the flow ofthe underfill resin) and the underfill resin 42 is disposed in such a way that it sticks out from the same main surface of the wiring chip 10 and surrounds the semiconductor chip implementation area (the implementation area of the memory chips 20 and the ASIC 30). In this case, the dam material 42A is shown in such a manner that it is disposed outside the semiconductor chip implementation area, but it can be disposed inside the semiconductor chip implementation area as well. However, the dam material 42A must be disposed outside the electrode group fabrication area.

The wiring chip 10 is formed in such a manner that a plurality of metal wires (for example, aluminum or copper wires) are disposed on a silicon board, which is not indicated in the figures. And as shown in the Fig. 1-3, one ends of such metal wires are connected to the connection pads 11A to implement memory chips 20 and the connection pads 11B to implement the ASIC 30, and the other ends of such metal wire are connected to the memory chips 20 and the ASIC 30, and the connection pads form a group. These connection pads 11A and 11B are made by conductive materials, such as aluminum.

The connection pads 11A and 11B of the wiring chip 10 are disposed along with the connection pads of the memory chips 20 and the ASIC 30 which are implemented. Needless to say, the connection pads 11A and 11B of the wiring chip 10 can be disposed either in a grid pattern, staggered pattern, or in other patterns in their disposition area, depending on the connection pads of the memory chips 20 and the ASIC 30 which are implemented.

The wring pitch between the connection pads 11A and 11B of the wiring chip 10 is set as appropriate depending on the chips which are implemented. For example, this embodiment requires two units of 256M bit multimedia memories as the memory chips 20, thus, corresponding to the bandwidth of such memories and the ASIC 30, the input/output bit number of the memory chips 20 needs to be minimum 256 bit x 2 =512 bit, and therefore for this particular implementation, alignment pitches of the connection pads 11A and 11B needs to be 20µm. However, it is not limited to 20µm, and the pitch can be anywhere between 20-60µm as appropriate.
Here is some explanation with respect to the bandwidth of the two units of 256M bit multimedia memories as the memory chips 20 and the ASIC 30 mentioned above. As mentioned before, the bandwidth is defined as a multiple ofthe semiconductor device's operational frequency and the number of input/output data (input/output bit number) of the semiconductor device.
For example, when the operating frequency ofthe semiconductor device in this embodiment is 33MHz and the number of input/output data is 256x2=512, the bandwidth is 2.1 GB/second.

The number of connection pads 11A and 11B of the wiring chip 10 also changes depending on the chips to be implemented. For example, this embodiment requires 2 units of 256M multimedia memory as the memory chips 20 and the ASIC 30, so the number of pads required is about 2500. The number of pads is not limited to 2500 and depending on the semiconductor chips which are implemented, the number of pads can be anywhere from 2000 to 5000 as appropriate.

The wiring chip 10comprises the same silicon board as the memory chips 20 and the ASIC 30. Therefore, it is highly resistant to heat, stretching and shrinking, and thus, reliable.

The memory chips 20 are developed utilizing the semiconductor process technology on the silicon board, and while it is not indicated in the figures, for example, they are 256M bit multimedia memories for this embodiment.

Also, the memory chips 20 are not limited to the 256M bit multimedia memories but they can be general dynamic random access memories (DRAMs). Similarly, they can be static random access memories (SRAMs) or non-volatile memories.

Further, as indicated in the Fig. 4, the memory chips comprises four divided memory banks 22A-22D (the first to fourth semiconductor circuit fabrication areas) in a rectangular shape on its main surface, and such memory banks 22A-22D comprise memory circuits (semiconductor circuits; not shown in the figures) which form memories. Also, while it is not indicated in the figures, the memory circuit comprises a plurality of memory cells, each of which are connected to a plurality of bit lines and word lines, and access circuits which select a designated memory cell from the plurality of memory cells depending on the given address signal.

In concrete, the memory bank 22A and the memory bank 22B are disposed in such a manner so that one side of the memory bank 22A and one side of the memory bank 22B face with each other with a certain amount of distance. Also, the memory bank 22A and the memory bank 22C are disposed in such a manner that the side of the memory bank 22A which crosses in the right angle with the side which faces with the memory bank 22B faces with one side of the memory bank 22C with a certain amount of distance. Similarly, the memory bank 22B and the memory bank 22D are disposed in such a manner that the side of the memory bank 22B which crosses in the right angle with the side which faces with the memory bank 22A faces with one side of the memory bank 22D with a certain amount of distance. Then, the memory bank 22C and the memory bank 22D are disposed in such a manner that the side of the memory bank 22C which crosses in the right angle with the side which faces with the memory bank 22A faces with one side of the memory bank 22D with a certain amount of distance.

In other words, on the main surface of the memory chips 20, four rectangular-shaped memory banks, the memory banks 22A-22D are disposed in such a manner that two sides crossing in the right angle face with each other with a certain amount of space, and the entire memory banks 22A-22D are disposed along the edge of the main surface (along the shape of the memory chips 20, which is a rectangle) of the memory chips 20. And on the surface ofthe memory chips 20, there is a space which has a shape of a cross formed by each memory banks 22A-22D facing with each other with a certain amount of distance.

The cross-shaped space is utilized as the connection bump disposition area 23 (electrode disposition area) to dispose connection bumps (projecting electrodes). The cross-shaped connection bump disposition area 23 is formed by the area 23A and 23B which cross with each other in the right angle.

In concrete, in the cross-shaped connection bump disposition area 23, the area 23A is the area where the space set between the memory bank 22A and the memory bank 22B as well as the memory bank 22C and 22D stretches in the direction from the memory bank 22A and 22B (in the direction to the memory bank 22C and 22B) to the both edges of the main surface of the memory chips 20. On the other hand, the area 23B is the area where the space set between the memory bank 22A and 22C and the memory bank 22B and 22D stretches in the direction from the memory bank 22A and 22C (in the direction to the memory bank 22B and 22D) to the both edges of the main surface of the memory chips 20.

And in the area 23A, the signal input/output connection bumps 21A (the first electrodes) of the memory chip 20 are disposed one after another in a group in the direction against the memory banks 22A and 22B (toward the direction of memory bank 22C and 22D). The disposition of the signal input/output connection bumps 21A can be either in a grid pattern or in a staggered pattern. In this case, there are signal input/output connection bumps 21A in the area where area 23A and 23B cross with each other and duplicate in the cross-shaped connection bump disposition area 23, but the embodiment is not limited in this manner, and the power/grounding connection bumps 21B can be disposed in stead in this duplicated area.

On the other hand, in the area 23B, the power/grounding connection bumps 21B (the second electrodes) are disposed one after another in a group, stretching in the direction against the memory banks 22A and 22C (toward the direction of memory bank 22B and 22D). These power/grounding connection bumps can be disposed either in a grid pattern, or in a staggered pattern.

In short, in this embodiment, the signal input/output connection bumps 21A and the power/grounding connection bumps 21B are disposed in the cross-shaped connection bump disposition area 23, forming a group of connection bumps in a cross shape.

The signal input/output connection bumps 21A and the power/grounding connection bumps 21B are disposed in such a manner that they have a certain amount of pitch between each bump. And it is recommended that the disposition pitch of the signal input/output connection bumps 21A (the number of bumps) is larger than the disposition pitch of the power/grounding connection bumps 21B (the number of bumps). Ir concrete, for example, the signal input/output connection bumps 21A (total number) in the area 23A are disposed as 13 (number in the width direction of the memory chips 20) x 122 (number in the direction of the elongated side of the memory chips 20) and the power/grounding connection bumps 21B (total number) are disposed as 8 (number in the width direction of the memory chips 20) x 103 (number in the direction of the elongated side of the memory chips 20). As such, it becomes possible to implement the memory chips 20 (memory circuit) and the wiring chip 10 as a flip chip. Also, by increasing the number of bumps (the number of pins), the power consumption and heat generation are reduced.

It depends on the layout specification of the memory chips 20 (memory circuit), but it is generally recommended hat the number of bumps (the number of electrodes) disposed and along in the width direction of the area 23A is between 10 and 30, and that the number of bumps (the number of electrodes) disposed and along in the width direction of area 23B is between 4 and 32. However, it is recommended that each bump (signal input/output connection bumps 21A and the power/grounding connection bumps 21B) is disposed in such a manner that it has a certain distance from the edge of the memory banks (the side facing with the bump) toward outside (for example, the minimum distance is equal to or more than 150 µm and the minimum distance is indicated as "t" in the Fig. 3 from the edge). Thus, in case each bump receives any pressure from external shocks caused during implementation or from outside of the memory device, the memory banks are not affected by such pressure which may be conducted via such bumps. Also, as such, it is ensured that the memory banks are resistant against the a ray generated by each bump and the data stored in the memory cell formed in the memory banks is not inverted.

It is not indicated in the figures, but right underneath the signal input/output connection bumps 21A (in the direction of the chip thickness), pads are disposed for formation of such bumps as well as unit cell areas are disposed which includes input/output circuits which are electrically connected to such bumps. Together with the signal input/output connection bumps 21A, the I/O array in which the unit cell areas including input/output circuits are disposed in an array form is composed.

The memory chip; 20 are disposed in such a manner that their connection pads configured as described above (signal input/output connection bumps 21A and the power/grounding connection bumps 21 B) are facing with the connection pads 11A of the wiring chip 10.

The memory chips 20 are disposed in such a manner that respective electrodes (bumps and pads) of the memory chips 20 and the wiring chip 10 are facing with each other, physically connected with the soldering 40 as well as electrically connected, and implemented as a flip chip on top of the wiring chip 10.

In this embodiment, in the cross-shaped bump disposition area 23, the memory chips 20 are implemented on top of the wiring chip 10 in such a manner that the area 23A is in parallel with the sides of memory chips 20 and the ASIC 30 which are facing with the area 23A. As such, the structure of the wiring chip to electrically connect the memory chips 20 and the wiring chip 10 is is simplified and connection problems can be avoided.

Also, each connection bump needs to be disposed on the both sides of the area 23A and the area 23B along its elongated sides, setting the center of these bumps as the center of the cross-shaped connection bump disposition area 23 (the area where the area 23A and 23B overlap with each other),and preferably, disposed symmetrically.

The ASIC 30 is developed utilizing the semiconductor process technology on the silicon board, and for example, a logic circuit including a general-purpose CPU is adopoted. In this embodiment, since two units of 256M bit multimedia memories are used as the memory chips 20, the input output bit number of the ASIC 30 is 512 bit, corresponding to the 2.1GB/seconds. Needless to say, depending on the performance of the memory chips 20 (such as their bandwidth), the input output bit number can be higher.

Also, the ASIC 30 is not limited to a logic circuit as mentioned above, but it can also utilize a general-purpose analog circuit, such as the one including an A/D converter which converts analog signals to digital signals.

On the ASIC 30, its connection bumps 31 are disposed in such a way along the edge, forming a group, facing with the memory chips 20. These power/grounding connection bumps 21B can be disposed either in a grid pattern or in a staggered pattern.

The ASIC 30 is disposed in such a manner that its connection bumps 31 face with the connection pads 11B of the wiring chip 10.

The ASIC 30 and the wiring chip 10 are disposed in such a manner that their respective electrodes (pads and bumps) are facing with each other, physically connected with the soldering 40 as well as electrically connected, thus the ASIC 30 is implemented as a flip chip on top of the wiring chip 10.

The memory chips 20 and the ASIC 30 are connected electrically and physically via metal wires (not shown in figures) connected to the connection pads of the wiring chip 10. Since ASIC 30 is electrically connected with two units of 256 bit multi media memories which are the memory chips 20, the input and output of signals are conducted in parallel in 512 bit chunks.

By connecting each connection bump of memory chips 20 with each connection bump of the ASIC 30 electrically via metal wires (not shown in figures) connected to the connection pads of the wiring chip 10, a bus line connection is realized.

It is not shown in the figures, but the wiring chip 10 comprises connection pads for external connection and by electrically connecting their connection wires, the memory device 100 is connected to outside.

As explained above, in the memory device 100 relating to the embodiment, the main surface of the memory chips are divided into four areas in which the memory circuits (semiconductor circuits; not shown in the figures) are formed, and these four areas are facing with each other with their two sides crossing in the right angles facing with each other with a certain amount of distance, shaping four of rectangular-shaped memory banks 22A-22D. Therefore, in the middle of the memory chips 20, there is a cross-shaped connection bump disposition area 23 which is formed by the memory banks 22A-22D which face with each other with a certain amount of distance. And in the area 23A in the cross-shaped connection bump disposition area 23, the signal input/output connection bumps 21A (the first electrc des) are disposed in a group. In short, the signal input/output connection bumps 21A are collectively disposed in a certain area, thus, the formation of signal input/output wiring to the divided semiconductor circuits is efficient and the space which electrodes occupy on the semiconductor chip is minimized.

On the other hand, a group of power/grounding connection bumps 21B is disposed in the area 23B which crosses in the right angle with the area 23A where the signal input/output bumps 21A are disposed in a group form. And when implementing the memory chips 20 on the wiring chip 10, the memory chips 20 are supported (via soldering) by the power/grounding connection bumps 21 B of the memory chips 20 so that the memory chips 20 do not tilt toward the crossing direction along the elongated side of the group of signal input/output connection bumps 21A of the memory chips 20, and the memory chips 20 are supported (via soldering) by the signal input/output connection bumps 21A so that the memory chips 20 do not tilt in the crossing direction along the elongated side of the power/grounding connection bumps 21B. In other words, the memory chips 20 are disposed in such a manner that they have a certain distance from the wiring chip 10. In short, the memory chips 20 and the wiring chip 10 face with each other in parallel. If the distance between the memory chips 20 and the wiring chip 10 is 20-30µm, it means that the space margin between the memory chips 20 and the wiring chip 10 is within from ±3µm to ±4µm range in terms ofthe entire area where the chips are facing with each other.

As a result, the parallel implementation of the memory chips 20 and the wiring chip 10 can be maintained with a minimum number of bumps. On the other hand, since the power/grounding connection bumps 21B for maintaining the parallel position are disposed in the non-fabrication area of the memory banks, it can be prevented that the memory circuit is damaged by a physical pressure caused when implementing the memory chips 20 onto the wiring chip 10. Also since the power/grounding connection bumps 21B are utilized to maintain the parallel position, connection to the power source and grounding are also strongly enforced.

Also, in this embodiment, the underfill resin 42 is filled between the memory chips 20 and the wiring chip 10 without the existence of any group of electrodes in the fabrication area of the memory bank. Also, since the memory banks of the memory chips 20 do not have any group of electrodes, there is no possibility of defects caused by the fill, and it is easy to fill the space completely with the underfill resin 42. As a result, the underfill resin 42 absorbs physical shocks sufficiently, thus the memory chips 20 are less likely to be damaged by physical shocks to the memory banks.

Further, in this embodiment, a group of the power/grounding connection bumps 21B is disposed in the area 23B which crosses with the area 23A in the right angle where there is a group of the signal input/output connection bumps 21A; in other words, it is disposed in the center space which is formed by the rectangular-shaped memory banks 22A-22D, making a group of the power/grounding connection bumps 21B the closest to each memory bank, thus supplying power and grounding to memory circuits (cells) formed in each memory bank evenly with the shortest wiring.

As such, in this embodiment, the number of electrodes (bumps) of the memory chips 20 are kept minimum, the parallel position of the memory chips 20 to the mounted substrate (wiring chip 10) is maintained, thus avoiding connection problems and preventing the semiconductor circuit (memory circuit) from being damaged.

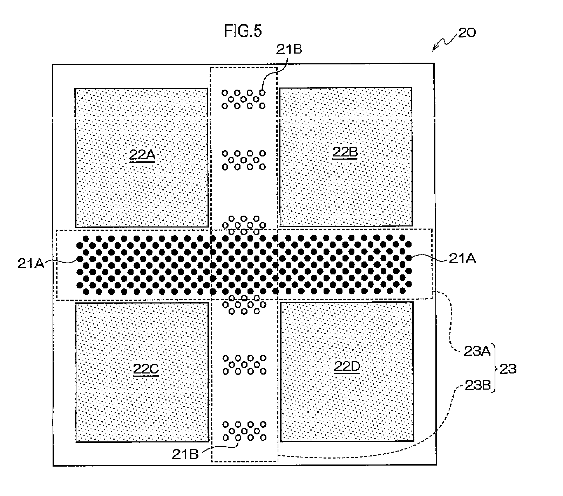

It this embodiment, the composition of a memory chip having a group of power/grounding connection bumps 21 B in the area 23B ofthe cross-shaped connection bump disposition area 23 as bumps (electrodes) to maintain a parallel implementation is explained, but the present invention is not limited to this composition. For example, as shown in the Fig.5, it can be the group of power/grounding connection bumps 21B, some of which are disposed densely and some of which are disposed thinly, in the area 23B of the cross-shaped connection bump disposition area 23.

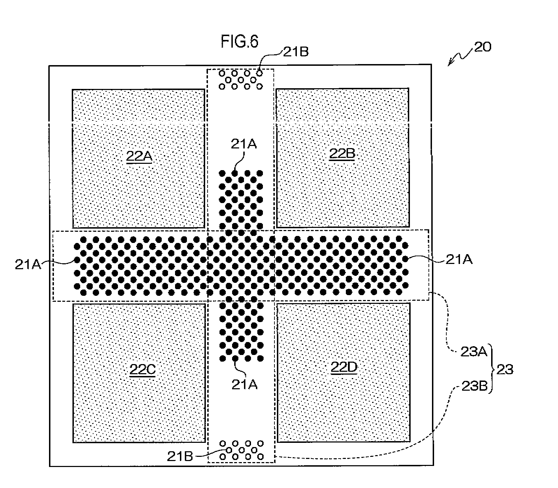

Also in this embodiment, the composition of a memory chip utilizing a group of power/grounding connection bumps 21 B in the area 23B of the cross-shaped connection bump disposition area 23 as bumps (electrodes) to maintain a parallel implementation is explained, but the present invention is not limited to this composition. For example, signal input/output connection bumps or dummy bumps can be utilized in stead of the power/grounding connection bumps 21B. In concrete, for example, as shown in the Fig. 6, a group of signal input/output connection bumps 21A which are disposed in the area 23A (where it overlaps with the area 23B) can be aligned continuously to the group of signal input/output connection bumps 21A which is disposed in the area 23B in the cross-shaped bump disposition area 23. In this case, the signal input/output connection bumps 21A are disposed from the center of the chip to the center of each memory bank which is facing with each other. And a group of power/grounding connection bumps 218 is disposed on the both edges of the area 23B toward its elongated sides (on the both edges of the chip).

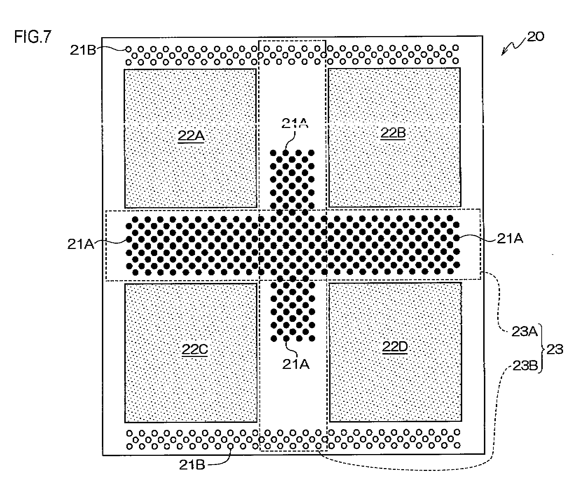

Also, in this embodiment, the composition of memory chips 20 comprising four divided memory banks 22A-22D which are disposed near the edges of the chip, but the present invention is not limited to this composition. For example, the composition can be in such a way that there is a certain space between the memory bank 22 and the edge of the chip. In concrete, for example, as shown in the Fig. 7, each memory bank can be disposed in such a manner that the memory bank 22A and the memory bank 22B have a certain space from the edge of the memory chip 20 (the edge toward the direction of the elongated sides of the area 23B) and similarly, the memory bank 22C and 22 have a certain space from the other edge of the memory chip 20 (the other side of the edge toward the direction of the elongated sides of the area 23B), and the power/grounding connection bumps 21B can be disposed in the spaces formed on the both edges. It is recommended that the power/grounding connection bumps 21 B which are disposed ir such spaces on such edges are disposed with a certain amount of distance from the edge of the memory bank (the side facing with the bumps) toward outside (for example, equal to or more than min mum 150µm from the edges: the minimum distance is shown as "t" in the Fig. 3). Besides these points, the composition of this case is the same is the composition shown in the Fig. 6.

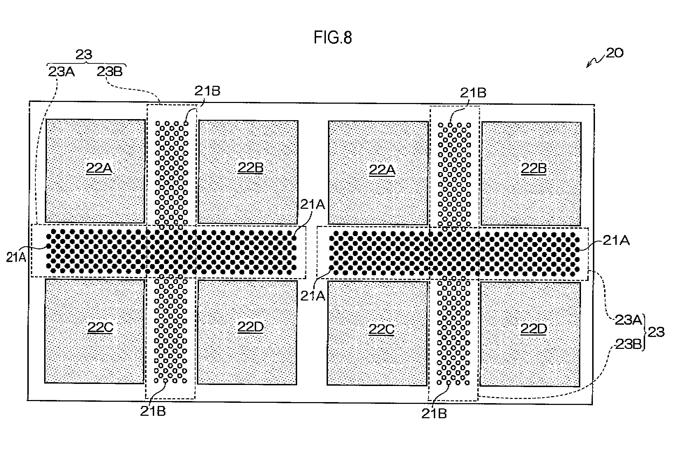

Also, in this embodiment, the composition of four memory banks was explained, but the present invention is not limited to this composition. In concrete, for example, as shown in the Fig. 8, it is possible to have two or more sets of four memory banks 22A-22D (including the cross-shaped connection bump disposition area 23) on the main surface of one memory chip.

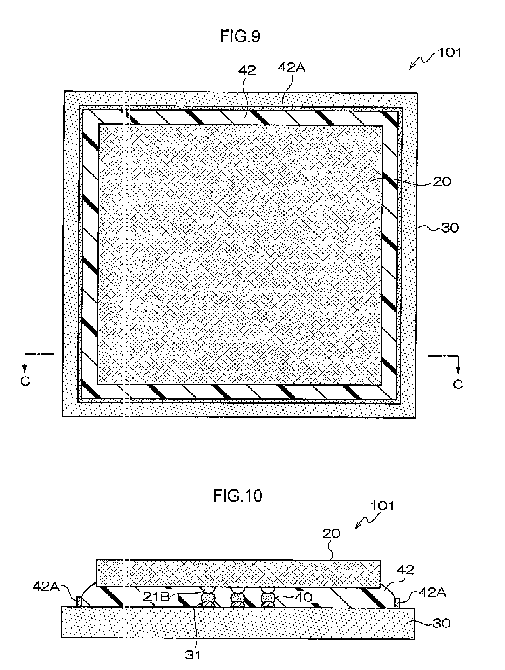

Also, in this embodiment, the composition of forming connection bumps in the cross-shaped connection bump disposition area 23 on the memory chips 20 is explained, but the present invention is not limited to this composition. The same method can be applied to the ASIC 30 which is divided into four logic circuits (semiconductor circuits). Also, in this embodiment, a composition to implement memory chips 20 and the ASIC 30 on the same main surface of the wiring chip 10 which is an interposer (mounted substrate) as a flip chip is explained, but an ASIC chip can be used in stead of the wiring chip 10 and it is possible to implement them as a COC (chip-on-chip) to compose a semiconductor device. In concrete, as shown in the Fig. 9 and Fig. 10, the semiconductor device 101 in which a memory chip 20 is implemented on the main surface of the ASIC 30 as a flip chip is an example. In this case, a group of electrodes of the ASIC 30 (connection bumps) are disposed in the same manner as a group of electrodes of the memory chip 20 (connection bumps).

### Explanation of Symbols

10: Wiring chip
11A, 11B: Connection pad
20: Memory chip
21A: Connection bump for signal input/output
21B: Connection bump for power/grounding
22A, 22B, 22C, 22D: Memory bank
23: Connection Bump Disposition Area
23A, 23B: Area
31: Connection bump
40: Soldering
42: Underfill resin
42A: Dam component
100: Semiconductor device
101: Semiconductor device

## Claims

1. A semiconductor chip, comprising:
four first to fourth rectangular-shaped semiconductor circuit forming areas, in which semiconductor circuits are respectively formed, and which are disposed such that two sides of the respective semiconductor circuit forming areas which intersect at a right angle face each other at predetermined intervals;
a cross-shaped e ectrode-disposition area constructed by first and second areas formed by gaps between the first to fourth semiconductor circuit forming areas and intersecting at a right angle;
a first electrode group which is disposed at least in a part of the first area of the cross-shaped electrode-disposition area, is connected to the semiconductor circuits, and supplies power or signals to the semiconductor circuits; and
a second electrode group which is disposed at least in a part of the second area of the cross-shaped electrode-disposition area, is connected to the semiconductor circuits, and supplies power or signals to the semiconductor circuits.

2. A semiconductor chip according to claim 1, wherein the first electrode group includes electrodes for signal input and output, and the second electrode group includes electrodes for power supply and grounding.

3. A semiconductor chip according to claim 1 or 2, wherein the semiconductor circuits is a memory circuit, and the semiconductor chip is a memory device chip.

4. A semiconductor device, comprising:
a wiring chip,
a first semiconductor chip mounted on a main face of the wiring chip with an electrode group thereof facing the main face; and
a second semiconductor chip which is different from the first semiconductor chip and is mounted on the main face of the wiring chip with an electrode group thereof facing the main face, wherein
the second semiconductor chip is the semiconductor chip according to any one of claims 1 to 3.

5. A semiconductor device, comprising:
a first semiconductor chip; and
a second semiconductor chip which is different from the first semiconductor chip and is mounted on a main face of the first semiconductor chip with an electrode group thereof facing the main face, wherein
the second semiconductor chip is the semiconductor chip according to any one of claims 1 to 3.
